(19) Europäisches Patentamt
European Patent Office
Office européen des brevets

(11) **EP 4 283 640 A1**

(12) **EUROPEAN PATENT APPLICATION**
published in accordance with Art. 153(4) EPC

(43) Date of publication:
**29.11.2023 Bulletin 2023/48**

(21) Application number: **22742845.5**

(22) Date of filing: **20.01.2022**

(51) International Patent Classification (IPC):
*H01F 27/32* (2006.01)   *H01F 27/24* (2006.01)
*H01F 27/30* (2006.01)   *H01F 27/34* (2006.01)
*G09F 9/00* (2006.01)   *H01F 27/26* (2006.01)
*H01F 27/28* (2006.01)   *H01F 27/29* (2006.01)
*H01F 27/06* (2006.01)

(52) Cooperative Patent Classification (CPC):
**G09F 9/00; H01F 27/06; H01F 27/24; H01F 27/26; H01F 27/28; H01F 27/29; H01F 27/30; H01F 27/32; H01F 27/34**

(86) International application number:
**PCT/KR2022/001022**

(87) International publication number:
**WO 2022/158869 (28.07.2022 Gazette 2022/30)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **22.01.2021 KR 20210009617**
**01.02.2021 KR 20210014157**

(71) Applicant: **LG Innotek Co., Ltd.**
**Seoul 07796 (KR)**

(72) Inventors:
• YU, Sun Young
  Seoul 07796 (KR)
• BAE, Seok
  Seoul 07796 (KR)
• SOHN, In Seong
  Seoul 07796 (KR)

(74) Representative: **Plasseraud IP**
**66, rue de la Chaussée d'Antin**
**75440 Paris Cedex 09 (FR)**

(54) **TRANSFORMER**

(57) A transformer, according to one embodiment, comprises: a core part; and a first coil part and a second coil part, of which at least a portion is received in the core part, wherein the second coil part has a plurality of conductive wires intersecting with each other in a specific region and thus may reduce the inductance deviation among the conductive wires, and a first coil of the first coil part may be provided with a terminal through a terminal bobbin.

FIG. 2A

**(Cont. next page)**

## FIG. 2B

**100**

140

110

150

120

130

1
3 • 2

## FIG. 2C

130        120      CL
C2  B2    C1  B1

110 { 111
      112

3
1 • 2

**Description**

[Technical Field]

The present disclosure relates to a transformer.

[Background Art]

Various coil parts, such as transformers or line filters, are mounted in power supply units of electronic devices.
A transformer may be included in electronic devices for various purposes. For example, a transformer may be used to perform an energy transfer function of transferring energy from one circuit to another circuit. In addition, a transformer may be used to perform a voltage-boosting or voltage reduction function of changing the magnitude of voltage. In addition, a transformer, which has characteristics in which only inductive coupling is exhibited between primary and secondary coils and thus no DC path is directly formed, may be used to block direct current and apply alternating current or to insulate between two circuits.

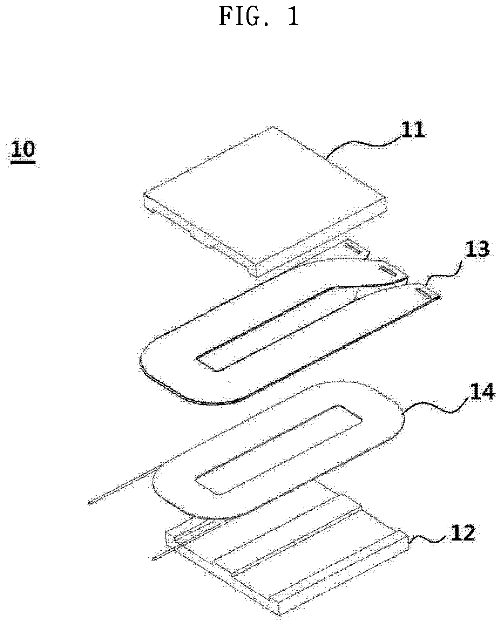

FIG. 1 is an exploded perspective view showing an example of the configuration of a general transformer.
Referring to FIG. 1, a general slim-type transformer 10 includes a core unit, which includes an upper core 11 and a lower core 12, and includes a secondary coil 13 and a primary coil 14, which are provided between the cores 11 and 12. In general, the secondary coil 13 is composed of a plurality of conductive metal plates, and the primary coil 14 takes the form of a wound conductive wire. In another configuration, a bobbin (not shown) may be disposed between the upper core 11 and the lower core 12.
In the transformer shown in FIG. 1, the primary coil and the secondary coil overlap each other in the vertical direction. When conductive wires are used for the secondary coil in place of the conductive metal plates, the primary coil and the secondary coil may be disposed so as to overlap each other in the horizontal direction.
However, when conductive wires are used for the secondary coil, the conductive wires need to be disposed parallel to each other when viewed in a plan view in order to realize slimness, and thus form turns around a center leg of a core unit. In this case, an inner conductive wire closest to the center leg is the shortest, and an outer conductive wire farthest from the center leg is the longest, whereby inductance variation occurs. This inductance variation causes current concentration, and the current concentration causes vigorous heat generation.

[ Disclosure]

[ Technical Problem]

A technical task of the present disclosure is to provide a transformer, which has a slim structure and is capable of reducing heat generation and preventing heat generation due to inductance variation caused by a length difference between conductive wires constituting a coil.
Another technical task of the present disclosure is to provide a slim-type transformer capable of being further slimmed and securing leakage inductance.
The technical tasks of the present disclosure are not limited to the above-mentioned technical tasks, and other technical tasks not mentioned herein will be clearly understood by those skilled in the art from the following description.

[Technical Solution]

A transformer according to an embodiment includes a core unit including an upper core and a lower core, a coil unit partially disposed in the core unit, and a bobbin unit disposed between the core unit and the coil unit, wherein the coil unit includes a first coil and a second coil at least partially disposed beside the first coil, wherein the bobbin unit includes a first bobbin having a first receiving portion formed therein to receive the first coil and a second bobbin having a second receiving portion formed therein to receive the second coil, wherein the first bobbin includes a first extended portion extending from the first receiving portion toward the second bobbin, and wherein the second receiving portion is disposed on the first extended portion.
The first bobbin may include a first top portion, a first bottom portion disposed below the first top portion, and a first middle portion disposed between the first top portion and the bottom portion, the first middle portion having a first through-hole defined by an inner side surface thereof. The first extended portion may be disposed on the first bottom portion.
The second bobbin may include a second top portion having a second through-hole formed in a center portion thereof, a second bottom portion disposed below the second top portion, and a second middle portion disposed between the second top portion and the second bottom portion. The first bobbin may be at least partially received in a recess defined by a lower surface of the second top portion and an inner side surface of the second middle portion.

The first extended portion may face the lower surface of the second bottom portion.

The second top portion may include a first guide and a second guide, which face each other in the long-axis direction of the second bobbin, with the second through-hole interposed therebetween, and each of the first guide and the second guide may protrude upwards from the upper surface of the second top portion, and may extend in the short-axis direction of the second bobbin.

The upper core may be disposed between the first guide and the second guide.

The second top portion may further include a third through-hole, which faces the second through-hole in the long-axis direction, with the second guide interposed therebetween.

The first top portion may further include a coil lead-out portion disposed on the upper surface thereof, and the coil lead-out portion may pass through the third through-hole to be exposed.

The second top portion may further include a blind hole formed in the lower surface thereof so as to extend to the interior of the second guide, and the first top portion may further include a protruding pin disposed between the coil lead-out portion and the first through-hole and protruding upwards from the upper surface thereof to be inserted into the blind hole.

The shortest distance from the lower surface of the lower core to the first coil and the shortest distance from the lower surface of the lower core to the second coil may be different from each other.

The shortest distance from the lower surface of the lower core to the first coil may be shorter than the shortest distance from the lower surface of the lower core to the second coil.

The second bobbin may include a second extended portion extending from the second receiving portion toward the first bobbin, and the first receiving portion may be disposed under the second extended portion.

A part of the second receiving portion may be disposed between the first coil and the second coil.

The core unit may include a first outer leg portion, a second outer leg portion, and a center leg portion disposed between the first outer leg portion and the second outer leg portion, and the shortest distance between the first coil and the second coil may be 0.1 times to 0.3 times the shortest distance from the outermost periphery of the first coil to one outer leg portion adjacent thereto, among the first outer leg portion and the second outer leg portion.

The core unit may further include a first space defined between the first outer leg portion and the center leg portion to receive a portion of the bobbin unit and a second space defined between the second outer leg portion and the center leg portion to receive another portion of the bobbin unit.

A ratio of a second distance, which is the shortest distance between the first coil and the second coil in the first space or the second space, to a first distance, which is the shortest distance between the first coil and the second coil in a region outside the first space and the second space, may be 1 to 1.3.

The shortest distance from the lower surface of the lower core to the first coil may be 0.3 to 0.7 times the shortest distance from the lower surface of the lower core to the second coil.

A flat panel display device according to another embodiment includes a power supply unit in which a transformer is disposed, wherein the transformer includes a core unit including an upper core and a lower core, a coil unit partially disposed in the core unit, and a bobbin unit disposed between the core unit and the coil unit, wherein the coil unit includes a first coil and a second coil at least partially disposed beside the first coil, wherein the bobbin unit includes a first bobbin having a first receiving portion formed therein to receive the first coil and a second bobbin having a second receiving portion formed therein to receive the second coil, wherein the first bobbin includes a first extended portion extending from the first receiving portion toward the second bobbin, and wherein the second receiving portion is disposed on the first extended portion.

A transformer according to still another embodiment includes a core unit including an upper core and a lower core, a first coil unit and a second coil unit at least partially disposed between the upper core and the lower core, and a terminal bobbin coupled to one side of the second coil unit in a first direction, wherein the first coil unit includes a first coil and a first bobbin having a first through-hole through which a center leg of the core unit passes, the first bobbin receiving the first coil, wherein the second coil unit includes a second coil and a second bobbin having a second through-hole receiving at least a portion of the first coil unit, the second bobbin receiving the second coil, wherein the terminal bobbin includes a plurality of first terminals disposed on one side of the terminal bobbin that is oriented in the first direction so as to be spaced apart from each other in a second direction intersecting the first direction and an opening formed in another side opposite the one side in the first direction to allow the one side of the second coil unit to be inserted thereinto, and wherein two end portions of the first coil are led out from the first bobbin and are respectively connected to different first terminals among the plurality of first terminals of the terminal bobbin.

The first bobbin may include a first top plate, a bottom plate spaced apart from the first top plate in a third direction intersecting the first direction and the second direction, and a first side wall disposed between the top plate and the bottom plate. The first top plate may include a lead-out hole allowing the two end portions to be led out to a region on the first top plate therethrough.

The terminal bobbin may include a recess formed in the other side thereof that is oriented in the first direction, and the recess may overlap the lead-out hole in the third direction.

The terminal bobbin may include a plurality of first wire guides, which respectively extend from the recess toward the plurality of first terminals, and two end portions of the first coil may be led out through the lead-out hole and may extend to corresponding first terminals along respectively different first wire guides among the plurality of first wire guides.

The second bobbin may include a second top plate, a second bottom plate spaced apart from the second top plate in a third direction intersecting the first direction and the second direction, and a second side wall disposed between the second top plate and the second bottom plate.

The transformer may include a first portion disposed on one side of the second bobbin that is oriented in the first direction with respect to the second through-hole and a second portion disposed on another side opposite the first portion with respect to the second through-hole. The second coil may include a plurality of conductive wires disposed around the second through-hole. One side of each of the plurality of conductive wires may extend so as to be disposed on the second portion, and another side of each of the plurality of conductive wires may extend such that two ends of each of the plurality of conductive wires are disposed on the first portion. A first conductive wire and a second conductive wire among the plurality of conductive wires at least partially overlap each other on the second portion. The second bobbin may include a recess at least partially overlapping, in the third direction, a region of the second portion on which the first conductive wire and the second conductive wire overlap each other.

The recess may be formed in the second bottom plate.

The second bobbin may further include a plurality of second terminals disposed on the second bottom plate in the first portion.

The first conductive wire and the second conductive wire may have a symmetrical shape in the first direction with respect to the second through-hole.

The plurality of conductive wires may further include a third conductive wire forming a turn outside the first conductive wire when viewed in a plan view and a fourth conductive wire forming a turn outside the second conductive wire when viewed in a plan view.

The third conductive wire and the first conductive wire may be disposed in parallel to form a turn, and the fourth conductive wire and the second conductive wire may be disposed in parallel to form a turn.

The second top plate may include a first partition wall portion, which protrudes upwards in the third direction from an edge of the first portion that is oriented in the first direction and extends in the second direction.

The second bobbin may further include a second wire guide, which extends in the first direction between the second side wall and the plurality of second terminals.

The second bobbin may further include a second partition wall portion, which protrudes downwards in the third direction from the second bottom plate between the second through-hole and the recess and extends in the second direction.

The second bobbin may further include a first support portion, which protrudes from the second partition wall portion toward the second through-hole in the first direction, and a second support portion, which faces the first support portion, with the second through-hole interposed therebetween, and the first support portion and the second support portion may support the first coil unit.

A circuit board according to still another embodiment includes a substrate and a transformer disposed on the substrate, wherein the transformer includes a core unit including an upper core and a lower core, a first coil unit and a second coil unit at least partially disposed between the upper core and the lower core, and a terminal bobbin coupled to one side of the second coil unit in a first direction, wherein the first coil unit includes a first coil and a first bobbin having a first through-hole through which a center leg of the core unit passes, the first bobbin receiving the first coil, wherein the second coil unit includes a second coil and a second bobbin having a second through-hole receiving at least a portion of the first coil unit, the second bobbin receiving the second coil, wherein the terminal bobbin includes a plurality of first terminals disposed on one side of the terminal bobbin that is oriented in the first direction so as to be spaced apart from each other in a second direction intersecting the first direction and an opening formed in another side opposite the one side in the first direction to allow the one side of the second coil unit to be inserted thereinto, and wherein two end portions of the first coil are led out from the first bobbin and are respectively connected to different first terminals among the plurality of first terminals of the terminal bobbin.

[ Advantageous Effects]

A transformer according to an embodiment is configured such that a plurality of conductive wires constituting a coil intersects each other in one region, thereby minimizing a length difference between the conductive wires.

In addition, terminal pins are short-circuited with each other, whereby inductance variation between conductive wires disposed in parallel to constitute the same turn is reduced, and therefore, heat generation is reduced.

In addition, since a bobbin has an opening formed in a region in which conductive wires intersect each other, it is possible to realize slimness.

In a transformer according to another embodiment, leakage inductance is secured by controlling a spacing distance between a first coil unit and a second coil unit.

In addition, an insulation distance is secured between a primary coil and a core due to the coupling structure of a first bobbin and a second bobbin, whereby leakage inductance may be secured.

The effects achievable through the present disclosure are not limited to the above-mentioned effects, and other effects not mentioned herein will be clearly understood by those skilled in the art from the following description.

[ Description of Drawings]

FIG. 1 is an exploded perspective view showing an example of the configuration of a general slim-type transformer.

FIG. 2A is a plan view of a transformer according to an embodiment.

FIG. 2B is a bottom view of the transformer according to the embodiment.

FIG. 2C is a cross-sectional view of the transformer according to the embodiment, taken along line A-A' in FIG. 2A.

FIG. 3A is a perspective view of a first bobbin according to an embodiment.

FIG. 3B is a plan view of the first bobbin according to the embodiment.

FIG. 4A is a plan view of a second bobbin according to an embodiment.

FIG. 4B is a perspective view of the second bobbin according to the embodiment.

FIG. 4C is a rear perspective view of the second bobbin according to the embodiment.

FIG. 5A is a plan view of a terminal bobbin according to an embodiment.

FIG. 5B is a perspective view of the terminal bobbin according to the embodiment.

FIG. 6 shows an example of disposition of adhesive portions of the transformer according to the embodiment.

FIG. 7A shows an example of disposition of a coil of a second coil unit according to an embodiment.

FIG. 7B illustrates a pin map of the second coil unit according to the embodiment, and FIG. 7C is a circuit diagram of the transformer according to the embodiment.

FIG. 7D is a view for explaining an overlapping pattern of conductive wires on a second portion of the second coil unit according to the embodiment.

FIG. 7E is a rear view of the second coil unit according to the embodiment, and FIG. 7F is a side view of the second coil unit according to the embodiment.

FIG. 7G is a plan view showing an example of the configuration of a second bobbin according to another embodiment.

FIG. 8A is a perspective view of a transformer according to still another embodiment.

FIG. 8B is a plan view of the transformer according to the still another embodiment.

FIG. 9 is an exploded perspective view of the transformer according to the still another embodiment.

FIG. 10 is a perspective view of a first bobbin according to still another embodiment.

FIG. 11 is an exploded perspective view of a bobbin unit according to still another embodiment.

FIG. 12 is a cross-sectional view of the transformer according to the still another embodiment, taken along line B-B' in FIG. 8B.

FIG. 13A is a cross-sectional view of the transformer according to the still another embodiment, taken along line A-A' in FIG. 8B.

FIG. 13B is an enlarged view of portion C in FIG. 13A.

FIG. 14 shows an example of the configuration of a circuit of a power supply unit of an electronic product.

[ Best Mode]

The present disclosure will now be described more fully hereinafter with reference to the accompanying drawings, in which various embodiments are shown. The examples, however, may be embodied in many different forms and should not be construed as being limited to the embodiments set forth herein. It is to be understood that the present disclosure covers all modifications, equivalents, and alternatives falling within the scope and spirit of the present disclosure.

While ordinal numbers including "second", "first", etc. may be used to describe various components, they are not intended to limit the components. These expressions are used only to distinguish one component from another component. For example, a second element could be termed a first element, and, similarly, a first element could be termed a second element, without departing from the scope of the present disclosure. As used herein, the term "and/or" includes any and all combinations of one or more of the associated listed items.

It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

In the description of the embodiments, it will be understood that when an element, such as a layer (film), a region, a pattern or a structure, is referred to as being "on" or "under" another element, such as a substrate, a layer (film), a region, a pad or a pattern, the term "on" or "under" means that the element is "directly" on or under another element or is "indirectly" formed such that an intervening element may also be present. It will also be understood that criteria of on or under is on the basis of the drawing. In addition, the thickness or size of a layer (film), a region, a pattern or a structure shown in the drawings may be exaggerated, omitted or schematically drawn for the clarity and convenience of explanation, and may not accurately reflect the actual size.

The terminology used herein is for the purpose of describing particular embodiments only and is not intended to be limiting of exemplary embodiments of the disclosure. As used herein, the singular forms are intended to include the plural forms as well, unless the context clearly indicates otherwise. It will be further understood that the term "include" or "have", when used herein, specifies the presence of stated features, integers, steps, operations, elements, components, or combinations thereof, but do not preclude the presence or addition of one or more other features, integers, steps, operations, elements, components, or combinations thereof.

Unless otherwise defined, all terms used herein, which include technical or scientific terms, have the same meanings as those generally appreciated by those skilled in the art. The terms, such as ones defined in common dictionaries, should be interpreted as having the same meanings as terms in the context of pertinent technology, and should not be interpreted as having ideal or excessively formal meanings unless clearly defined in the specification.

Hereinafter, a transformer according to an embodiment will be described in detail with reference to the accompanying drawings.

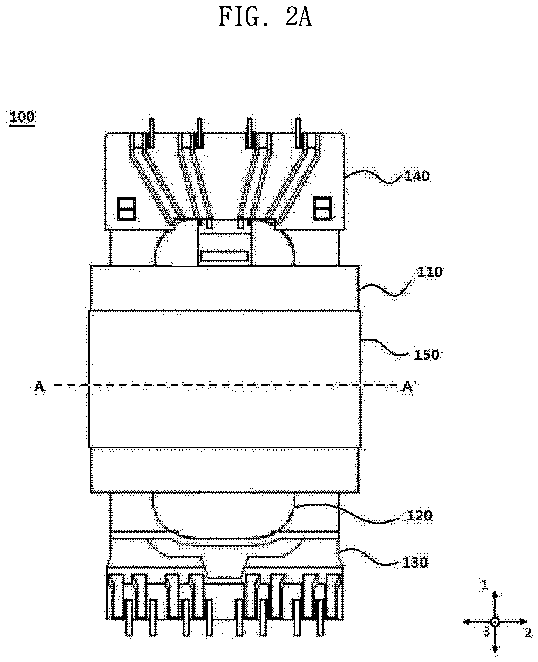

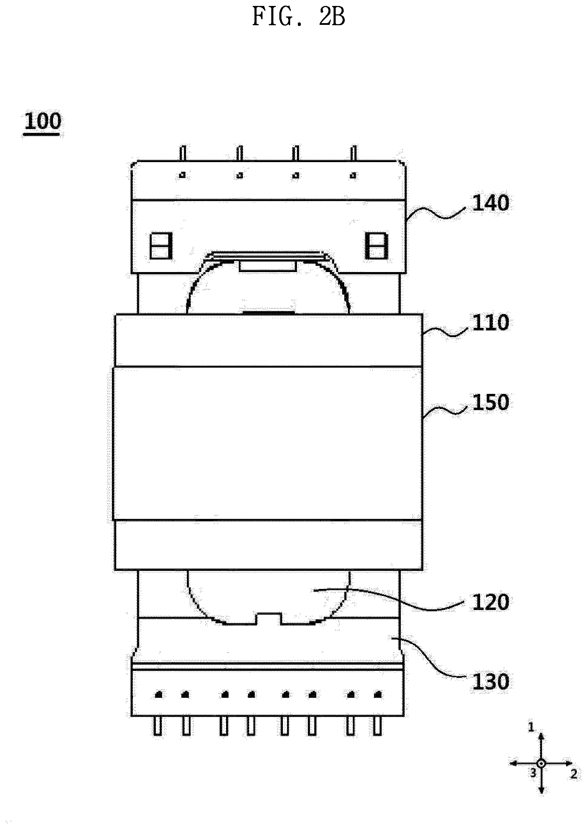

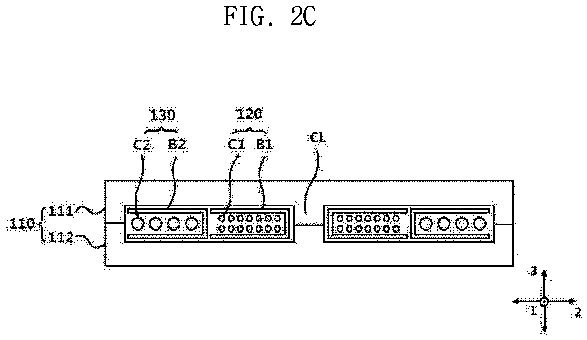

FIG. 2A is a plan view of a transformer according to an embodiment, FIG. 2B is a rear view of the transformer according to the embodiment, and FIG. 2C is a cross-sectional view of the transformer according to the embodiment, taken along line A-A' in FIG. 2A.

Referring to FIGs. 2A to 2C together, a transformer 100 according to an embodiment may include a core unit 111 and 112, a first coil unit 120, a second coil unit 130, a terminal bobbin 140, and a core fixing unit 150. Hereinafter, respective components will be described in detail.

The core unit 111 and 112 may have a function of a magnetic circuit, and thus may serve as a path for magnetic flux. The core unit 111 and 112 may include an upper core 111, which is disposed at an upper position, and a lower core 112, which is disposed at a lower position. The two cores 111 and 112 may be formed to be symmetrical or asymmetrical with each other in the vertical direction. However, for convenience of explanation, the following description will be given on the assumption that the two cores are formed to be vertically symmetrical with each other.

Each of the upper core 111 and the lower core 112 may include a body portion, which has a flat plate shape, and a plurality of leg portions, which protrude from the body portion in a thickness direction (i.e. a third-axis direction) and extend in a predetermined direction. The plurality of leg portions may include two outer legs, which extend in one axis direction (here a first-axis direction) and are spaced apart from each other in another axis direction (here a second-axis direction) when viewed in a plan view, and one center leg CL, which is disposed between the two outer legs.

When the upper core 111 and the lower core 112 are coupled to each other in the vertical direction, each of the outer legs and the center leg of the upper core 111 faces a corresponding one of the outer legs and the center leg of the lower core 112. In this case, a gap having a predetermined distance (e.g. 10 to 200 um, without necessarily being limited thereto) may be formed between at least one pair among the pairs of outer legs and the pair of center legs, which face each other. The size of the gap may be a space defined between the upper core 111 and the lower core 112, which are spaced apart from each other, and the gap may be filled with air (i.e. an air gap), or may be filled with an adhesive material.

In addition, the core unit 111 and 112 may include a magnetic material, for example, iron or ferrite, but the disclosure is not necessarily limited thereto.

The first coil unit 120 may include a first bobbin B1 having a first through-hole CH1 (or a first cavity) formed in a center thereof and a first coil C1 wound around the first through-hole CH1 in a receiving space in the first bobbin so as to form a plurality of turns.

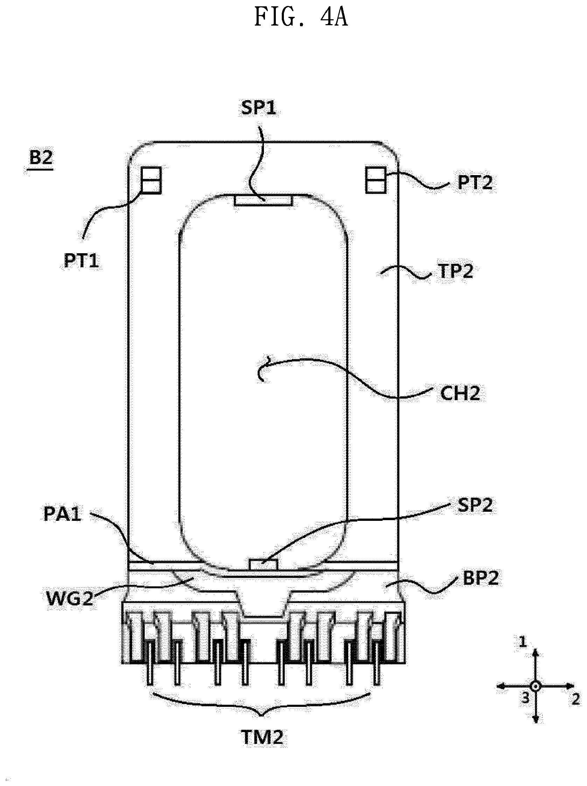

The second coil unit 130 may include a second bobbin B2 having a second through-hole CH2 (refer to FIG. 4A) (or a second cavity) formed in a center thereof and a second coil C2 disposed around the second through-hole CH2 in a receiving space in the second bobbin B2 so as to form a turn. Here, at least a portion of the first coil unit 120 may be disposed in the second through-hole CH2. Therefore, at least a portion of the first coil unit 120 and at least a portion of the second coil unit 130 may overlap each other in the first-axis direction and the second-axis direction. Each of the first coil C1 and the second coil C2 may be a multiple-turn winding in which a rigid metal, for example, a copper conductive wire, is wound multiple times in a spiral or planar spiral shape, but the disclosure is not necessarily limited thereto. For example, an enamel wire (USTC wire) wrapped by a fiber yarn, a Litz wire, a triple insulated wire (TIW), or the like may be used for the first coil C1.

In some embodiments, the first coil unit 120 may correspond to a primary coil of the transformer 100, and the second coil unit 130 may correspond to a secondary coil of the transformer 100. However, the disclosure is not necessarily limited thereto.

In addition, the diameter of the second coil C2 may be 0.7 to 0.9 times the height of the second bobbin B2 in the third-axis direction, but the disclosure is not necessarily limited thereto.

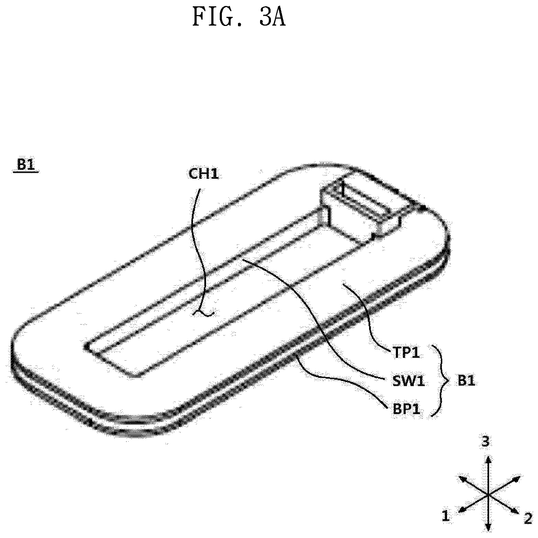

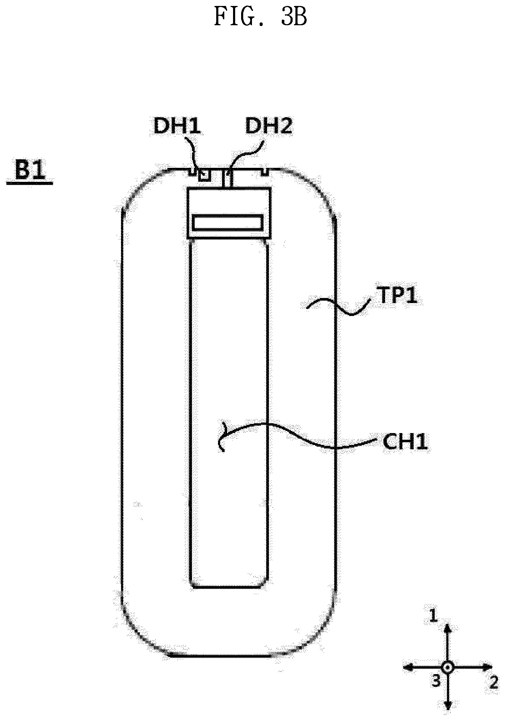

The first coil unit 120 will be described in more detail with reference to FIGs. 3A and 3B, and the second coil unit 130 will be described in more detail with reference to FIGs. 4A to 4C.

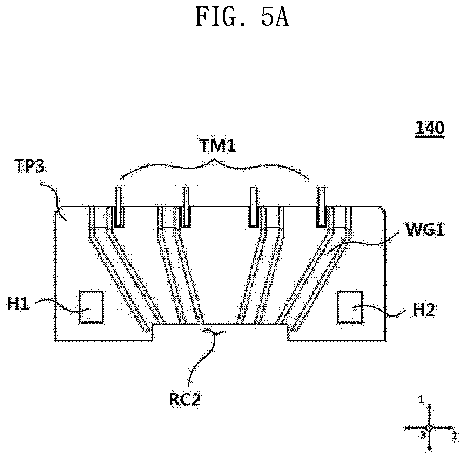

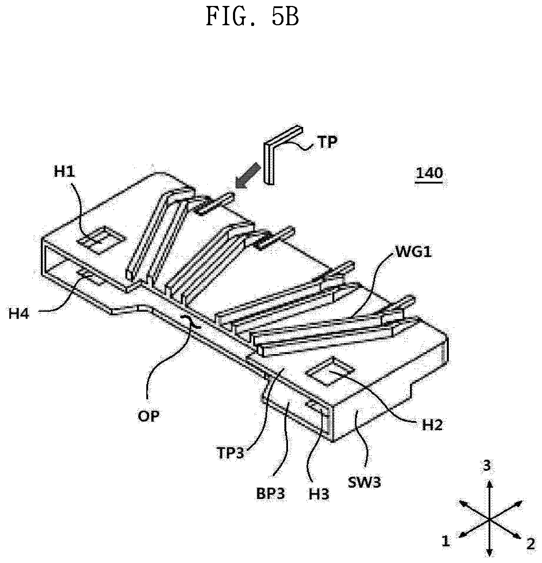

In the state in which the first coil unit 120 and the second coil unit 130 are coupled to each other, the terminal bobbin 140 is coupled thereto so as to be oriented in the first-axis direction, and is provided with a terminal, via which the first coil C1 is electrically connected to an external circuit (not shown). A detailed configuration of the terminal bobbin 140 will be described later in more detail with reference to FIGs. 5A and 5B.

The core fixing unit 150 is provided to ensure stable coupling between the upper core 111 and the lower core 112. The core fixing unit may be implemented by winding a sheet of polymer resin tape on the outer surface of the core unit 110 at least once in the second-axis and third-axis directions, but the disclosure is not necessarily limited thereto.

FIG. 3A is a perspective view of the first bobbin according to the embodiment, and FIG. 3B is a plan view of the first bobbin according to the embodiment.

Referring to FIGs. 3A and 3B, the first bobbin B1 according to the embodiment may include a first top plate TP1, a first bottom plate BP1, and a first side wall SW1 disposed between the first top plate TP1 and the first bottom plate BP1. The first side wall SW1 may define the first cavity CH1, and may define a receiving space, in which the first coil C1 is received, together with the lower surface of the first top plate TP1 and the upper surface of the first bottom plate BP1.

The first top plate TP1 may have a first lead-out hole DH1 and a second lead-out hole DH2 formed in an edge of a portion thereof to which the terminal bobbin 140 is coupled in the first-axis direction. One of the two end portions of the conductive wire constituting the first coil C1 may be led out upwards through the first lead-out hole DH1, and the remaining end portion of the first coil C1 may be led out upwards through the second lead-out hole DH2. The two end portions of the first coil C1 respectively led out through the first lead-out hole DH1 and the second lead-out hole DH2 may extend to a region above the terminal bobbin 140. In addition, the first lead-out hole DH1 and the second lead-out hole DH2 may overlap second recesses RC2 in the terminal bobbin 140, which will be described later, in the third-axis direction.

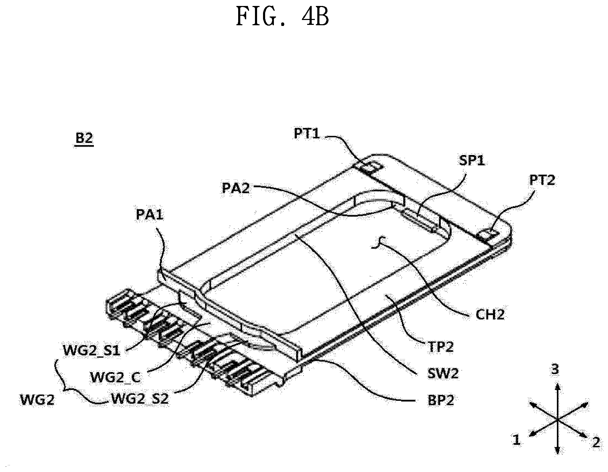

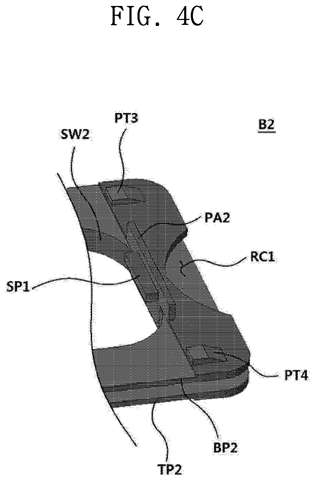

FIG. 4A is a plan view of the second bobbin according to the embodiment, FIG. 4B is a perspective view of the second bobbin according to the embodiment, and FIG. 4C is a rear perspective view of the second bobbin according to the embodiment.

Referring to FIGs. 4A to 4C, the second bobbin B2 according to the embodiment may include a second top plate TP2, a second bottom plate BP2, and a second side wall SW2 disposed between the second top plate TP2 and the second bottom plate BP2. The second side wall SW2 may define the second cavity CH2, and may define a receiving space, in which the second coil C2 is received, together with the lower surface of the second top plate TP2 and the upper surface of the second bottom plate BP2.

A first protruding portion PT1 and a second protruding portion PT2, which protrude upwards in the third-axis direction, may be disposed on a portion of the second top plate TP2 to which the terminal bobbin 140 is coupled in the first-axis direction, and a first partition wall portion PA1, which is bent and extends upwards in the third-axis direction, may be disposed on an edge of a portion of the second top plate TP2 that is opposite the terminal bobbin 140 in the first-axis direction.

A third protruding portion PT3 protruding downwards in the third-axis direction, a fourth protruding portion PT4, a second partition wall portion PA2, a first support portion SP1, and a first recess RC1 may be disposed on one of the portions of the second bottom plate BP that are oriented in the first-axis direction. In addition, a plurality of second terminals TM2 and a second support portion SP2 may be disposed on the opposite one of the portions of the second bottom plate BP that are oriented in the first-axis direction. The plurality of second terminals TM2 may be disposed parallel to each other while being spaced apart from each other in the second-axis direction.

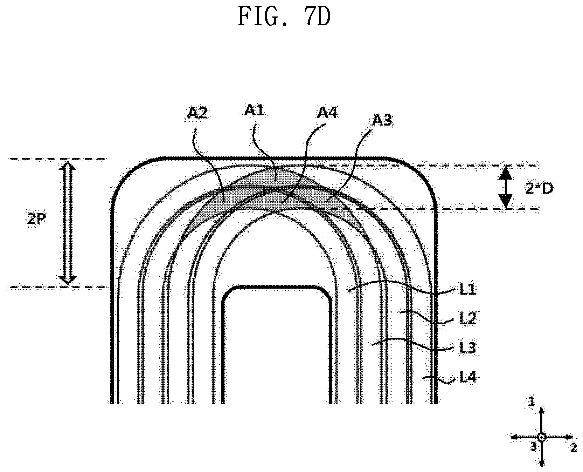

The first recess RC1 may have a planar shape that is depressed in one side end of the second bottom plate BP toward the opposite side thereof. The width of the first recess RC1 in the second-axis direction may gradually decrease from one side end toward the opposite side. For example, the first recess RC1 may have a semicircular or semielliptical planar shape, but the disclosure is not necessarily limited thereto. A portion of the second coil C2 may be exposed through the first recess RC1, which will be described later in more detail with reference to FIGs. 7D to 7F.

The second partition wall portion PA2 may extend in the second-axis direction, and the first support portion SP1 may protrude from the second partition wall portion PA2 toward the opposite side, i.e. the center of the second cavity CH2, in the first-axis direction. The second support portion SP2 may protrude toward one side in the first-axis direction, and may support the first coil unit 120 together with the first support portion SP1 when the first coil unit 120 is inserted into the second cavity CH2 from above to below in the third-axis direction.

Meanwhile, a second wire guide WG2 may be disposed between the first partition wall portion PA1 and the plurality of terminals TM2 when viewed in a plan view. The second wire guide WG2 may include a center portion WG2_C and side portions WG2_S1 and WG2_S2. The center portion WG2_C may protrude from the second side wall portion SW2 toward the second terminals TM2, and the width thereof in the second-axis direction may gradually decrease toward the second terminals TM2. The side portions WG2_S1 and WG2_S2 may have a plate shape, and may be disposed so as to connect the lower end of the first partition wall portion PA1 to the center portion WG2_C. For example, each of the side portions WG2_S1 and WG2_S2 may have an arc-shaped plane that connects the lower end of the first partition wall portion PA1 to the center portion WG2_C, and the second wire guide WG2 may have a T-shaped plane.

The second wire guide WG2 may serve to guide a conductive wire disposed at the innermost position among the plurality of conductive wires constituting the second coil C2. In addition, the plurality of conductive wires (not shown) constituting the second coil C2 is exposed upwards at a portion at which the second top plate TP2 and the second bottom plate BP2 do not overlap each other in the third-axis direction, i.e. between the first partition wall portion PA1 and the second terminals TM2 when viewed in a plan view. Therefore, the side portions WG2_S1 and WG2_S2 of the second wire guide WG2 may contribute to securing insulation distances between the second coil C2 and the first coil C2 and between the second coil and the core unit 110 together with the first partition wall portion PA1.

The protruding portions PT1, PT2, PT3, and PT4 may be respectively fitted into holes H1, H2, H3, and H4 in the terminal bobbin 140, which will be described later, so that the second bobbin B2 and the terminal bobbin 140 are coupled and secured to each other.

FIG. 5A is a plan view of the terminal bobbin according to the embodiment, and FIG. 5B is a perspective view of the terminal bobbin according to the embodiment.

Referring to FIGs. 5A and 5B together, the terminal bobbin 140 may include a third top plate TP3, a third bottom plate BP3, and a third side wall SW3 disposed between the third top plate TP3 and the third bottom plate BP3.

A first hole H1, a second hole H2, and first wire guides WG1 may be disposed on the third top plate TP3, and a third hole H3 and a fourth hole H4 may be disposed in the third bottom plate BP3.

An opening OP is formed in one side of the terminal bobbin 140, on which the third side wall SW3 is not disposed, so that the second coil unit 130 is inserted thereinto in the first-axis direction, and a plurality of first terminals TM1 is disposed on the side of the terminal bobbin 140 that is opposite the opening in the first-axis direction. The second recesses RC2 may be respectively formed in the third top plate TP3 and the third bottom plate BP3 so as to be disposed above and below the opening OP in the third-axis direction and to be depressed toward the opposite side in the first-axis direction. In this case, the second recess formed in the third top plate TP3 and the second recess formed in the third bottom plate BP3 may have different planar shapes, but the disclosure is not necessarily limited thereto. The planar shapes of the second recesses RC2 may preferably be set such that the terminal bobbin 140 coupled to the first coil unit 120 and to the second coil unit 130 does not shield the first coil unit 120 (i.e. does not overlap the first coil unit 120 in the third-axis direction) or shields a minimum required portion of the first coil unit 120. The reason for this is to prevent heat generated from the first coil C1 of the first coil unit 120 from being trapped by the terminal bobbin 140.

Each of the plurality of first wire guides WG2 may extend from the second recess RC2 toward a respective one of the first terminals TM1. The number of first terminals TM1 and the number of first wire guides WG1 may be identical to each other, but the disclosure is not necessarily limited thereto. One end of the first coil C1 may be led out through any one of the lead-out holes DH1 and DH2 in the first bobbin B1, and may be exposed upwards through the second recess RC2 formed in the third top plate TP3. The exposed end of the first coil C1 may extend toward the first terminal TM1 along the first wire guide WG1, and may be electrically connected to the first terminal TM1.

Each of the plurality of first terminals TM1 may be implemented as a terminal pin TP, which extends in the first-axis direction and is bent in the third-axis direction. The portion of the terminal pin TP that extends in the first-axis direction may be electrically connected and secured to one end portion of the first coil C1 through soldering, and the portion of the terminal pin TP that extends in the third-axis direction may penetrate the terminal bobbin 140 downwards in the third-axis direction to be exposed downwards from the terminal bobbin 140. The portion exposed downwards from the terminal bobbin 140 may be electrically connected and secured to the circuit board. The configuration of the first terminal TM1 using the terminal pin TP may also be applied to the second terminal TM2.

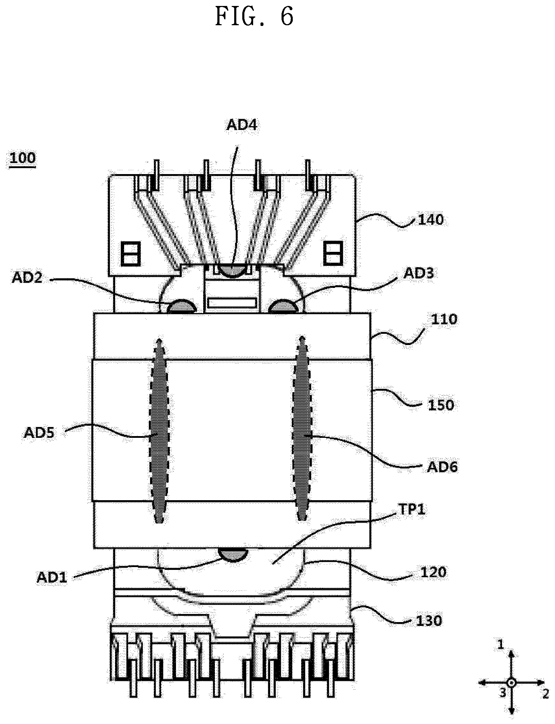

The transformer 100 according to the embodiment may include a plurality of adhesive portions in addition to the above-described core fixing unit 150 in order to ensure higher reliability. This will be described with reference to FIG. 6.

FIG. 6 shows an example of disposition of the adhesive portions of the transformer according to the embodiment.

Referring to FIG. 6, first to third adhesive portions AD1, AD2, and AD3 may be disposed between the first top plate TP1 of the first bobbin B1 of the first coil unit 120 and the surface of the core unit 110 that has the opening, whereby the core unit 110 and the first coil unit 120 may be coupled to each other more firmly.

In addition, a fourth adhesive portion AD4 may be disposed between the second recess RC2 in the terminal bobbin 140 and the first top plate TP1.

In addition, a fifth adhesive portion AD5 and a sixth adhesive portion AD6 may be disposed so as to extend along a contact line between the first coil unit 120 and the second coil unit 130 in the first-axis direction. Of course, the fifth adhesive portion AD5 and the sixth adhesive portion AD6 may be in contact with the lower surface of the body portion of the upper core 111 or the upper surface of the body portion of the lower core 112 as well as the contact line between the first coil unit 120 and the second coil unit 130.

Each adhesive portion may be an adhesive resin, but the disclosure is not necessarily limited thereto. In addition, although not shown, adhesive portions may also be formed on coupling portions between the first to fourth protruding portions PT1, PT2, PT3, and PT4 and the first to fourth holes H1, H2, H3, and H4.

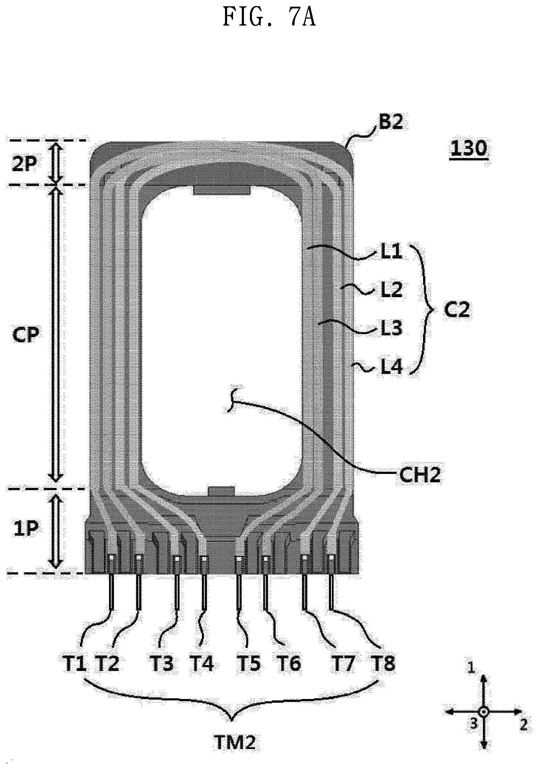

Hereinafter, disposition of the second coil C2 according to the embodiment will be described in more detail with reference to FIGs. 7A to 7G.

FIG. 7A shows an example of disposition of the coil of the second coil unit according to the embodiment.

Although the second coil C2 is illustrated in FIG. 7A as being disposed on the second bobbin B2 for convenience of explanation, it should be noted that, in practice, the second coil C2 is disposed between the second top plate TP2 and the second bottom plate BP2 of the second bobbin B2.

Referring to FIG. 7A, the second bobbin B2 may include a center portion CP, a first portion 1P, which is located on one side of the center portion CP or the second through-hole CH2 in the first-axis direction, and a second portion 2P, which is located on the other side of the center portion CP or the second through-hole CH2, which is opposite the first portion 1P in the first-axis direction.

The second through-hole CH2 may be disposed in the center portion CP, and a plurality of terminal pins T1, T2, T3, T4, T5, T6, T7, and T8 constituting the second terminals TM2 may be disposed parallel to each other in the second-axis direction on the first portion 1P.

The second coil C2 may include a plurality of conductive wires L1, L2, L3, and L4.

Each of the plurality of conductive wires L1, L2, L3, and L4 may have two ends, each of which is electrically connected to a respective one of the plurality of terminal pins T1, T2, T3, T4, T5, T6, T7, and T8, and may form one turn around the second through-hole CH2.

For example, the two ends of the first conductive wire L1 are connected to the second terminal pin T2 and the fifth terminal pin T5, and the two ends of the third conductive wire L3 are respectively connected to the first terminal pin T1 and the sixth terminal pin T6. In addition, the two ends of the second conductive wire L2 are respectively connected to the fourth terminal pin T4 and the seventh terminal pin T7, and the two ends of the fourth conductive wire L4 are respectively connected to the third terminal pin T3 and the eighth terminal pin T8.

Meanwhile, the first conductive wire L1 and the third conductive wire L3 may intersect the second conductive wire L2 and the fourth conductive wire L4 on the second portion 2P so as to at least partially overlap the second conductive wire L2 and the fourth conductive wire L4 in the third-axis direction. In addition, the plurality of conductive wires L1, L2, L3, and L4 may be disposed parallel to each other in the second-axis direction on the center portion CP, and may extend in the first-axis direction. Although illustrated in FIG. 7A as not overlapping each other in the third-axis direction on the center portion CP, the plurality of conductive wires L1, L2, L3, and L4 may partially overlap each other in the third-axis direction in a region adjacent to the second portion 2P. That is, one side of each of the plurality of conductive wires L1, L2, L3, and L4 may extend so as to be disposed on the second portion 2P, and another side thereof may extend such that the two ends thereof are disposed on the first portion 1P.

Due to the above-described configuration of the second coil unit 130, the conductive wires constituting the second coil C2 partially overlap each other on the second portion 2P. However, since each individual conductive wire forms only one turn, it can be understood that the second coil C2 is wound in one layer.

The connection structure of the terminal pins and intersection on the second portion 2P described above are established for inductance matching between portions forming the same turn from a circuit point of view.

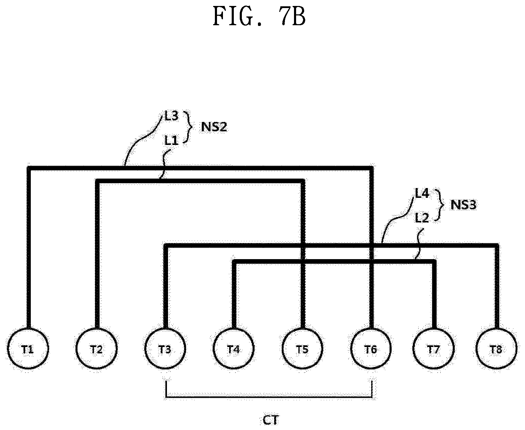

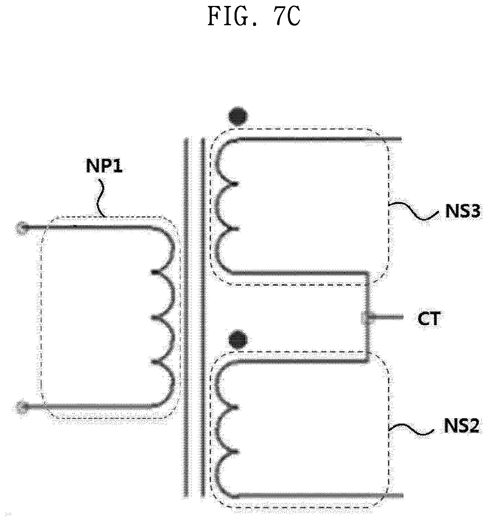

This will be described with reference to FIGs. 7B and 7C.

FIG. 7B illustrates a pin map of the second coil unit according to the embodiment, and FIG. 7C is a circuit diagram of the transformer according to the embodiment.

Referring to FIGs. 7B and 7C, the first conductive wire L1 and the third conductive wire L3 are connected in parallel to each other to form a first turn portion NS2 for a first signal of the secondary coil unit of the transformer, and the second conductive wire L2 and the fourth conductive wire L4 form a second turn portion NS3 for a second signal of the second coil unit. In this case, the first terminal pin T1 and the second terminal pin T2 correspond to an input terminal for the first signal, and the fifth terminal pin T5 and the sixth terminal pin T6 correspond to a ground for the first signal. In addition, the seventh terminal pin T7 and the eighth terminal pin T8 correspond to an input terminal for the second signal, and the fourth terminal pin T4 and the fifth terminal pin T5 correspond to a ground for the second signal. Here, the grounds for the signals may be electrically connected to each other to form a so-called center tap (CT) structure.

Referring back to FIG. 7A, due to the above-described connection between the conductive wires and the terminal pins, the first conductive wire L1 and the third conductive wire L3, which are disposed in parallel to constitute the first turn portion NS2, are mirror images of (symmetrical with) the second conductive wire L2 and the fourth conductive wire L4, which are disposed in parallel to constitute the second turn portion NS3, in the first-axis direction with respect to the second through-hole CH2 when viewed in a plan view. Therefore, the first turn portion NS2 and the second turn portion NS3 have substantially the same conductive wire configuration, and thus, inductance variation due to a length difference between conductive wires may be minimized, leading to reduction in generation of heat due to current concentration.

Meanwhile, since the conductive wires intersect each other on the second portion 2P of the second bobbin B2, the conductive wires may overlap each other in the third-axis direction. Therefore, it is necessary to ensure the height of the second side wall SW2 of the second bobbin B2 to be at least twice the thickness of the conductive wire in order to prevent deformation of the second bobbin B2 at the second portion 2P. However, ensuring the height of the second side wall SW2 may cause the second bobbin B2 to become thick as a whole, which may increase the overall thickness of the transformer. This will be described with reference to FIG. 7D.

FIG. 7D is a view for explaining an overlapping pattern of the conductive wires on the second portion of the second coil unit according to the embodiment. In FIG. 7D, for better understanding, the conductive wires L1, L2, L3, and L4 are shown by solid lines regardless of overlapping.

Referring to FIG. 7D, a plurality of overlapping regions is generated on the second portion 2P of the second coil unit according to the overlapping pattern of the pairs of the plurality of conductive wires. For example, a first region A1 in which the third conductive wire L3 and the fourth conductive wire overlap each other when viewed in a plan view, a second region A2 in which the first conductive wire L1 and the fourth conductive wire L4 overlap each other when viewed in a plan view, a third region A3 in which the second conductive wire L2 and the third conductive wire L3 overlap each other when viewed in a plan view, and a fourth region A4 in which the first conductive wire and the second conductive wire overlap each other when viewed in a plan view are generated on the second portion 2P.

These regions A1, A2, A3, and A4 require a larger receiving space in the third-axis direction than the remaining regions.

Therefore, the first recess RC1 may be formed in the second bobbin B2 in order to prevent increase in the thickness of the second bobbin B2.

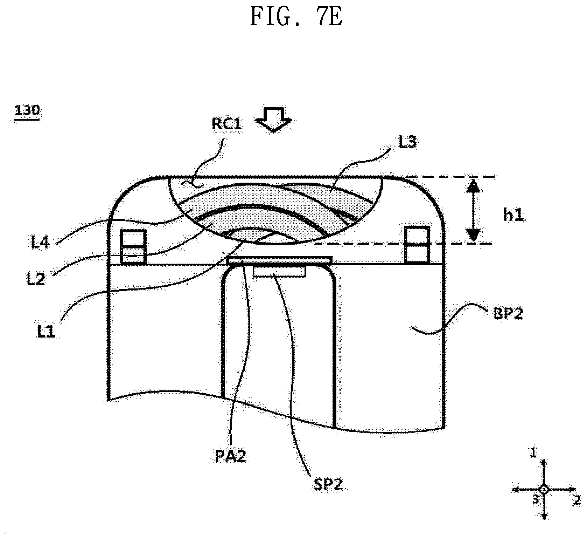

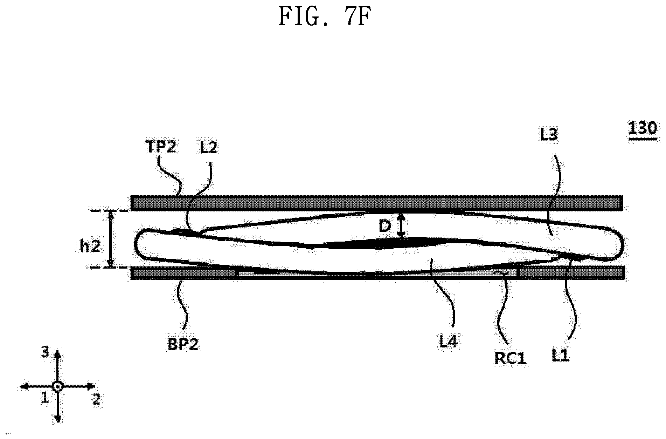

FIG. 7E is a rear view of the second coil unit according to the embodiment, and FIG. 7F is a side view of the second coil unit shown in FIG. 7E when viewed in an arrow direction in the upper part in FIG. 7E.

Referring to FIGs. 7E and 7F together, the first recess RC1 having a semicircular planar shape is formed in the second bottom plate BP2 of the second coil unit 130. Although the height h2 of a receiving space (i.e. the height of the second side wall SW2) is less than twice the diameter D of the conductive wire, as shown in FIG. 7F, a space for intersection between the conductive wires may be secured without deformation of the bobbin due to the first recess RC1. Therefore, increase in the thickness of the second bobbin B2 may be prevented.

Meanwhile, it is preferable that the maximum length h1 of the first recess RC1 in the first-axis direction be greater than twice (2*D) the diameter of each conductive wire, as shown in FIG. 7D. In addition, it is preferable for the first recess RC1 to be formed at a position encompassing at least a portion of each of the four regions A1, A2, A3, and A4, which are generated by overlapping between the conductive wires shown in FIG. 7D. In addition, it is preferable that the planar area of the first recess RC1 be 50% to 90% of the sum of the areas of the four regions A1, A2, A3, and A4 generated by overlapping between the conductive wires, but the disclosure is not necessarily limited thereto.

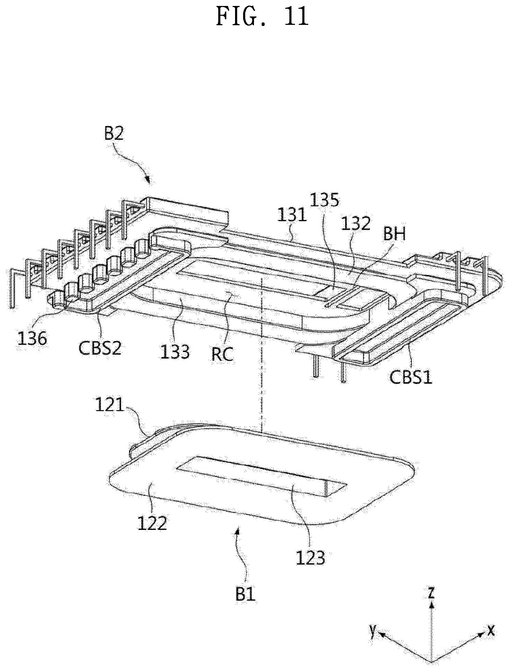

In addition, the first recess RC1 is illustrated in FIG. 11A as having a semicircular planar shape, but this is merely illustrative. The planar shape of the first recess is not limited to any specific shape, for example, a circular shape, a track-like shape, or a polygonal shape, so long as the same is capable of encompassing at least a portion of each of the four regions A1, A2, A3, and A4 generated by overlapping between the conductive wires.

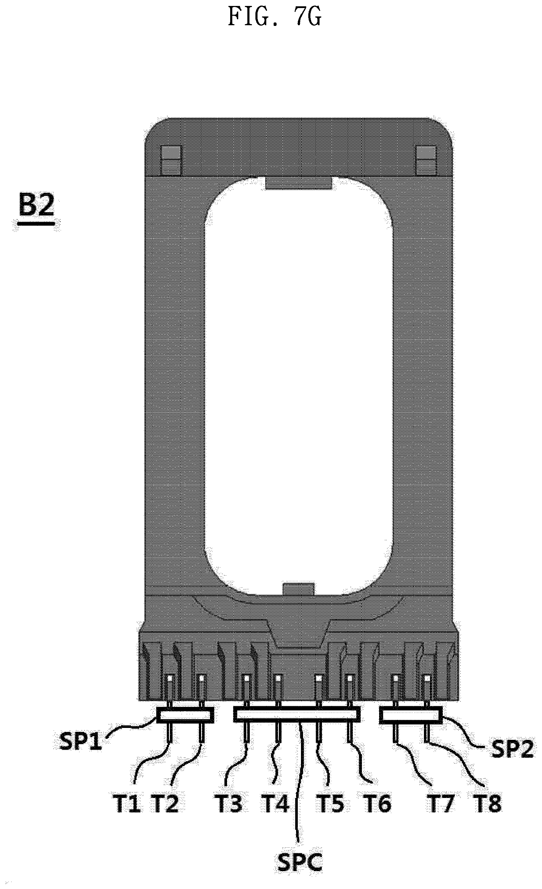

FIG. 7G is a plan view showing an example of the configuration of a second bobbin according to another embodiment.

The configuration of a second bobbin B2 according to another embodiment shown in FIG. 7G is the same as the configuration of the second bobbin B2 described above with reference to FIG. 4A, except for short-circuiting portions SP1, SPC, and SP2, and thus duplicate description will be omitted.

Referring to FIG. 7G, the first terminal pin T1 and the second terminal pin T2, which correspond to the input terminal for the first signal, may be short-circuited through a first short-circuiting portion SP1. In addition, the seventh terminal pin T7 and the eighth terminal pin T8, which correspond to the input terminal for the second signal, may be short-circuited through a second short-circuiting portion SP2. In addition, the third to sixth terminal pins T3, T4, T5, and T6, which correspond to the ground of the center tap configuration, may be short-circuited through a center short-circuiting portion SPC.

Here, each of the short-circuiting portions SP1, SP2, and SPC may be implemented through soldering. However, this is merely illustrative, and the disclosure is not necessarily limited thereto. Any of various schemes capable of short-circuiting the terminal pins may be used. For example, each of the short-circuiting portions SP1, SP2, and SPC may be implemented through a conductive clip, a conductive pin, or a combination thereof and soldering.

Although the center short-circuiting portion SPC is illustrated in FIG. 7G as being of an integral type and short-circuiting all of the third to sixth terminal pins T3, T4, T5, and T6, a center short-circuiting portion SPC according to another aspect may include a first center short-circuiting portion (not shown) for short-circuiting the third terminal pin T3 and the fourth terminal pin T4 and a second center short-circuiting portion (not shown) for short-circuiting the fifth terminal pin T5 and the sixth terminal pin T6. In this case, the first center short-circuiting portion (not shown) and the second center short-circuiting portion (not shown) may not be electrically connected to each other in the transformer.

Meanwhile, as described above, the transformer 100 according to the embodiment may constitute a circuit board (not shown) constituting a power supply unit (PSU) together with other magnetic elements (e.g. an inductor).

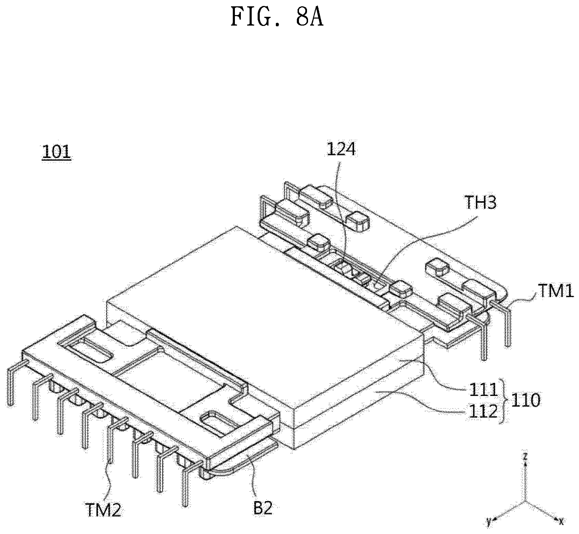

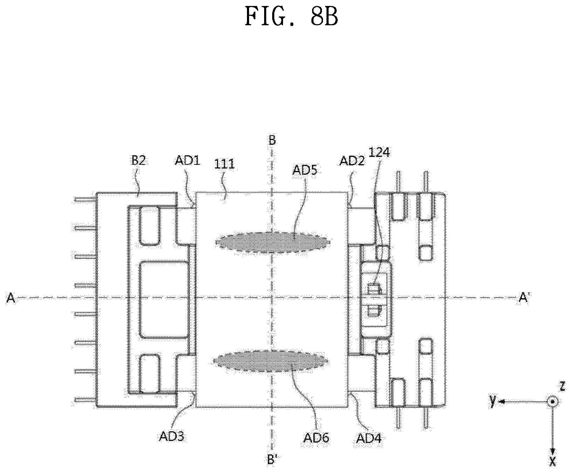

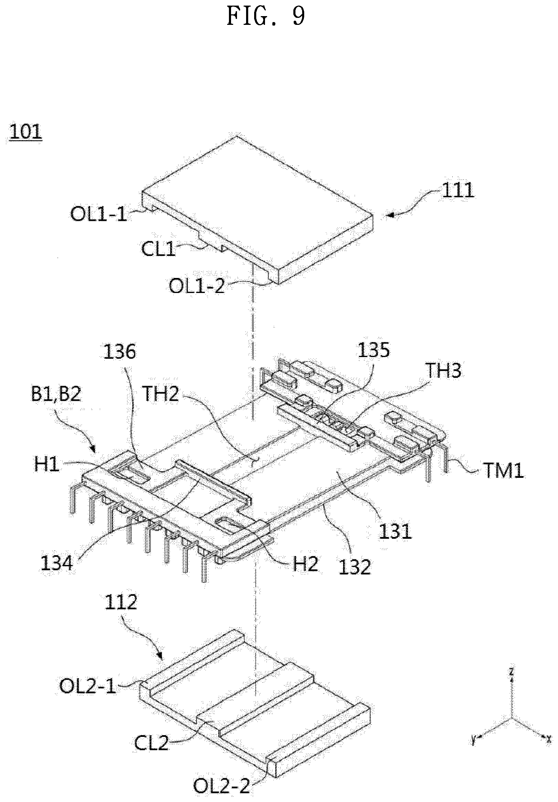

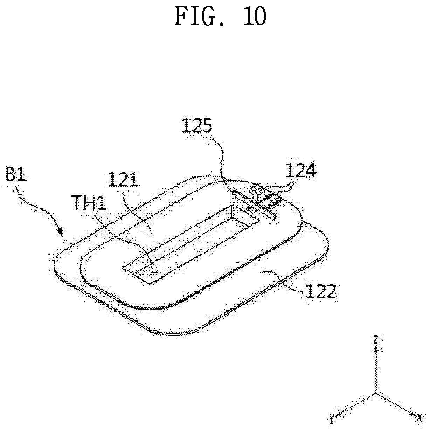

FIG. 8A is a perspective view of a transformer according to still another embodiment, and FIG. 8B is a plan view of the transformer according to the still another embodiment. In addition, FIG. 9 is an exploded perspective view of the transformer according to the still another embodiment, and FIG. 10 is a perspective view of a first bobbin according to the still another embodiment. In addition, FIG. 11 is an exploded perspective view of a bobbin unit according to the still another embodiment.

Referring to FIGs. 8A to 11 together, a transformer 101 according to still another embodiment may include a core unit 110, a bobbin unit B1 and B2, and terminals TM1 and TM2. Hereinafter, respective components will be described in detail.

The core unit 111 and 112 may have a function of a magnetic circuit, and thus may serve as a path for magnetic flux. The core unit 111 and 112 may include an upper core 111, which is disposed at an upper position, and a lower core 112, which is disposed at a lower position. The two cores 111 and 112 may be formed to be symmetrical or asymmetrical with each other in the vertical direction. However, for convenience of explanation, the following description will be given on the assumption that the two cores are formed to be vertically symmetrical with each other.

Each of the upper core 111 and the lower core 112 may include a body portion, which has a flat plate shape, and a plurality of leg portions OL1-1, OL1-2, OL2-1, OL2-2, CL1, and CL2, which protrude from the body portion in a thickness direction (i.e. a Z-axis direction) and extend in a predetermined direction. For example, the plurality of leg portions OL1-1, OL1-2, and CL1 of the upper core 111 may include two outer legs OL1-1 and OL1-2, which extend in one axis direction (here a Y-axis direction) and are spaced apart from each other in another axis direction (here an X-axis direction) when viewed in a plan view, and one center leg CL1, which is disposed between the two outer legs OL1-1 and OL1-2.

When the upper core 111 and the lower core 112 are coupled to each other in the vertical direction, each of the outer legs OL1-1 and OL1-2 and the center leg CL1 of the upper core 111 faces a corresponding one of the outer legs OL2-1 and OL2-2 and the center leg CL2 of the lower core 112. One pair of outer legs OL1-1 and OL2-1, which face each other, may be referred to as first outer leg portions, the other pair of outer legs OL1-2 and OL2-2, which face each other, may be referred to as second outer leg portions, and the pair of center legs CL1 and CL2, which face each other, may be referred to as center leg portions.

A gap having a predetermined distance (e.g. 10 to 200 um, without necessarily being limited thereto) may be formed between at least one pair among the pairs of outer legs and the pair of center legs, which face each other. The sizes of the gaps between the one pair of center legs and between each of the two pairs of outer legs may be adjusted in order to control the inductance of the core unit 110, and the amount of heat that is generated may be controlled by varying the number of gaps.

In addition, the core unit 110 may include a magnetic material, for example, iron or ferrite, but the disclosure is not necessarily limited thereto.

Because the core unit 110 surrounds a portion of the outer periphery of the bobbin unit 120 and 130, it can be seen that a portion of a first coil unit (not shown) and a portion of a second coil unit (not shown), which are received in the bobbin unit 120 and 130, are disposed inside the core unit 110.

The bobbin unit 120 and 130 may include a first bobbin B1 and a second bobbin B2.

The first bobbin B1 and the second bobbin B2 may respectively have a first through-hole TH1 and a second through-hole TH2 formed therein, and the center legs CL1 and CL2 of the core unit 110 may be aligned so as to pass through the first through-hole TH1 and the second through-hole TH2.

At least a portion of the first bobbin B1 may be received in the second bobbin B2, and may include a first top portion 121, a first middle portion 123, and a first bottom portion 122.

Each of the first top portion 121 and the first bottom portion 122 may have a quadrangular planar shape having rounded corners, but the disclosure is not necessarily limited thereto. In addition, the first bottom portion 122 may have a planar shape extending farther outwards than the first top portion 121 in the direction in which the leg portions are spaced apart from each other (i.e. the X-axis direction).

The first middle portion 123 may be disposed between the first top portion 121 and the first bottom portion 122 in the vertical direction, and may electrically isolate the center leg portions from conductive wires (not shown) constituting the first coil unit. The inner side surface of the first middle portion 123 may define the first through-hole TH1. In addition, the space defined by the lower surface of the first top portion 121, the outer side surface of the first middle portion 122, and a portion of the upper surface of the first bottom portion may function as a receiving space for receiving the conductive wires constituting the first coil unit.

The second bobbin B2 may include a second top portion 131, a second middle portion 133, a second bottom portion 132, and board support portions CBS1 and CBS2.

The second middle portion 133 may be disposed between the second top portion 131 and the second bottom portion 132 in the vertical direction, and may electrically isolate conductive wires (not shown) constituting the second coil unit from the conductive wires (not shown) constituting the first coil unit. In addition, the space defined by a portion of the lower surface of the second top portion 131, the outer side surface of the second middle portion 132, and a portion of the upper surface of the second bottom portion may function as a receiving space for receiving the conductive wires constituting the second coil unit.

In addition, the board support portions CBS1 and CBS2, which are spaced apart from each other in the long-axis direction of the second bottom portion 132, may function to support the transformer 101 when the transformer 101 is mounted on a circuit board (not shown) of a device such as a PSU. A plurality of protruding portions 136 may be formed near the second board support portion CBS2 located adjacent to the second terminal TM2, among the board support portions, so as to protrude downwards and to be disposed parallel to each other while being spaced apart from each other in the y-axis direction. The protruding portions 136 may support the transformer 101 on the board together with the second board support portion CBS2, and may also serve as wire guides to guide end portions of the conductive wires constituting the second coil unit, which are led out between the second top portion 131 and the second bottom portion 132, to extend to the second terminal TM2.

A second through-hole TH may be disposed in the center portion of the second top portion 131, and the terminals TM1 and TM2 may be disposed on respective ends of the second top portion 131 in the long-axis direction thereof. The terminals TM1 and TM2 may function to fix the transformer 101 to the board (not shown) of the power supply unit (PSU), and may function as paths for electrical connection between the first and second coil units (not shown) of the transformer 101 and the board (not shown) of the power supply unit (PSU).

In more detail, the first terminal TM1 may include a plurality of pins, which are spaced apart from each other, and any one of the two ends of the conductive wire constituting the first coil unit may be electrically connected to at least one of the plurality of pins. For example, some of the plurality of pins constituting the first terminal TM1 may be located opposite the other pins along the x-axis and may be disposed parallel to each other along the y-axis, and the other pins may be disposed parallel to each other along the y-axis.

The second terminal TM2 may include a plurality of pins, which are disposed parallel to each other while being spaced apart from each other along the x-axis, and any one of the two ends of the conductive wire constituting the second coil unit may be electrically connected to at least one of the plurality of pins.

A first guide 134 and a second guide 135 are disposed on the upper surface of the second top portion 131 so as to face each other in the long-axis direction of the second bobbin B2 (i.e. the Y-axis direction), with the second through-hole TH2 interposed therebetween, and to extend in the short-axis direction (i.e. the X-axis direction). Here, the first guide 134 may be disposed adjacent to the second terminal TM2, and the second guide may be disposed adjacent to the first terminal TM1. The upper core 111 may be located between the first guide 134 and the second guide 135, and may serve to fix the location of the upper core 111 and to increase an insulation distance between the upper core 111 and the terminals TM1 and TM2.

In addition, a reinforcing pattern portion 136 may be disposed between the second terminal TM2 and the first guide 134 on the upper surface of the second top portion 131. For example, the reinforcing pattern portion 136 may be formed such that patterns having an F-shaped plane are disposed opposite each other in the X-axis direction, but the disclosure is not necessarily limited thereto. The rigidity of the second top portion 131 may be increased by the reinforcing pattern portion 136, whereby deformation thereof may be prevented. Due to a height difference between the reinforcing pattern portion 136 and the second top portion 131, a plurality of recesses H1 and H2 may be formed so as to extend in the X-axis direction, and may serve to increase an insulation distance between the upper core 111 and the second terminal TM2.

When the transformer 101 is constructed, at least a portion of the first bobbin B1 may be received in a recess RC defined by the lower surface of the second top portion 131 and the inner side surface of the second middle portion 133 of the second bobbin B2.

In addition, in the state in which the first bobbin B1 and the second bobbin B2 are coupled to each other, the upper surface of the first top portion 121 faces the lower surface of the second top portion 131, and the portion of the upper surface of the first bottom portion 122 that does not overlap the first top portion 121 in the vertical direction (i.e. the portion extending outwards) faces the lower surface of the second bottom portion 132.

In addition, in the coupled state, a coil lead-out portion 124 of the first top portion 121 may pass through a third through-hole TH3 in the second top portion 131, and may be exposed upwards. By virtue of the coil lead-out portion 124, the two ends of the conductive wire constituting the first coil unit may be easily led out and secured to the upper surface of the second top portion 131, and may be directly connected to the first terminal TM1.

In addition, a protruding pin 125 is disposed between the first through-hole TH1 and the coil lead-out portion 124 on the upper surface of the first top portion 131 of the first bobbin B1 so as to protrude upwards and extend in the X-axis direction. When the first bobbin B1 and the second bobbin B2 are coupled to each other, the protruding pin 125 may be inserted into a blind hole BH formed in the lower surface of the second top portion 131 at a position corresponding to the second guide 135. Accordingly, the first bobbin B1 and the second bobbin B2 may be coupled to each other more firmly and stably, and the sections thereof in the coupled state are shown in FIG. 6A.

Meanwhile, a configuration for adhering the bobbin unit B1 and B2 and the core unit 110 to each other may be considered in order to achieve firm coupling therebetween. For example, as shown in FIG. 1B, a first adhesive group AD1, AD2, AD3, and AD4 may be disposed in a side bonding manner between the outer legs of the core unit 110 and portions of the bobbins B1 and B2 that extend from the receiving space in the core unit 110 in the Y-axis direction so as to be exposed. For example, the first adhesive group AD1, AD2, AD3, and AD4 may be in contact with or may not be in contact with the bobbins B1 and B2. It is preferable that the first adhesive group AD1, AD2, AD3, and AD4 be in contact with both the upper core 111 and the lower core 112 so that the upper core 111 and the lower core 112 are secured to each other.

In addition, a second adhesive group AD5 and AD6 may be disposed between portions of the lower surface of the upper core 111, which correspond to regions between the center leg and the outer legs, and the upper surface of the second bobbin B2. By virtue of the above-described adhesive portions AD1, AD2, AD3, AD4, AD5, and AD6, vibration attributable to gaps between the bobbins B1 and B2 and the core unit 110 may be prevented. Here, the first adhesive group AD1, AD2, AD3, and AD4 and the second adhesive group AD5 and AD6 may be implemented as an adhesive having the same component, or may be implemented as adhesives having different components. It is preferable that the second adhesive group AD5 and AD6 be implemented as an adhesive resin, but the disclosure is not necessarily limited thereto.

The received state of each of the first coil unit and the second coil unit due to the above-described coupling structure of the bobbin unit B1 and B2 will be described with reference to FIG. 5.

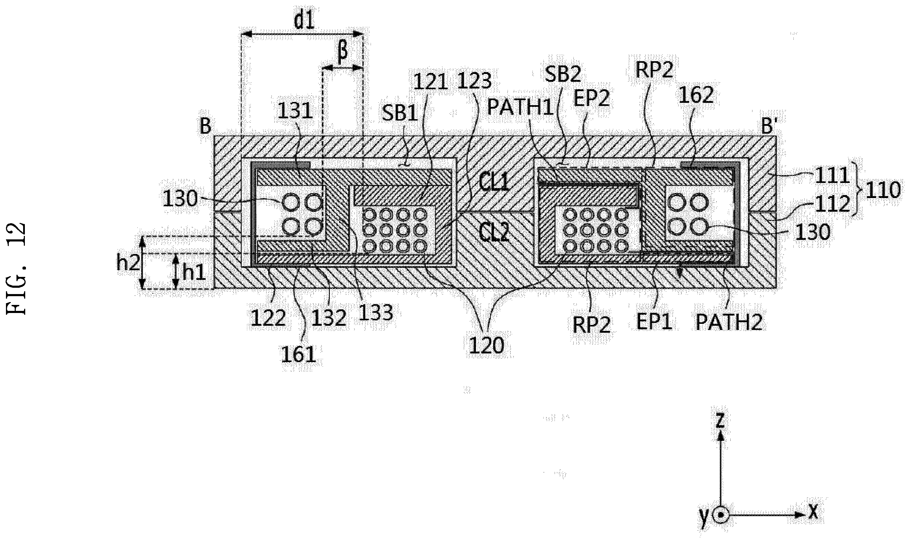

FIG. 12 is a cross-sectional view of the transformer according to the embodiment, taken along line B-B' in FIG. 8B.

Referring to FIG. 12, the bobbins B1 and B2 are disposed between the core unit 110 and the coil units 120 and 130. In more detail, the coil units 120 and 130 and the bobbins B1 and B2 are partially disposed in a first space SB1 and a second space SB2 in the core unit 110. The first space SB1 and the second space SB2 may be spaced apart from each other in the direction in which the leg portions are spaced apart from each other (i.e. the X-axis direction), with the center leg portions CL1 and CL2 interposed therebetween, and may be formed such that a rectangular plane extends in the Y-axis direction. In addition, the first space SB1 may be located between the center leg portions CL1 and CL2 and the outer leg portions OL1-1 and OL2-1 located on one side of the core unit 110, and the second space SB2 may be located between the center leg portions CL1 and CL2 and the outer leg portions OL1-2 and OL2-2 located on the opposite side of the core unit 110.

The first bobbin B1 may have a first receiving portion RP1 receiving the first coil unit 140 and a first extended portion EP1 extending from the first receiving portion RP1 toward the second bobbin 130. That is, the first receiving portion RP1 may correspond to the first top portion 121, the first middle portion 123, and a part of the first bottom portion 122 except for the first extended portion EP1.

The second bobbin 130 may have a second receiving portion RP2 receiving the second coil unit 130 and a second extended portion EP2 extending from the second receiving portion RP2 toward the first bobbin B1. That is, the second receiving portion RP2 may include a part of the second top portion 131 except for the second extended portion EP2, the second middle portion 133, and the second bottom portion 132.

In addition, the second receiving portion RP2 is disposed on the first extended portion EP1, and the first receiving portion RP1 is disposed under the second extended portion EP2. Accordingly, the shortest distance h1 from the lower surface of the lower core 112 to the first coil unit 120 is different from the shortest distance h2 from the lower surface of the lower core 112 to the second coil unit 130. That is, the shortest distance h1 from the lower surface of the lower core 112 to the first coil unit 120 is shorter than the shortest distance h2 from the lower surface of the lower core 112 to the second coil unit 130. For example, the shortest distance h1 from the lower surface of the lower core 112 to the first coil unit 120 may be 0.3 to 0.7 times the shortest distance h2 from the lower surface of the lower core 112 to the second coil unit 130.

In addition, due to the above-described coupling structure of the bobbin unit B1 and B2, a portion of the first coil unit 120 and a portion of the second coil unit 130 overlap each other in a direction from the outer leg portions located on one side toward the outer leg portions located on the opposite side, and the remaining portions thereof do not overlap each other. The first coil unit 120 and the second coil unit 130 may not overlap each other in the vertical direction.

At least a portion of the second coil unit 130 is disposed beside the first coil unit 120, and a part of the second receiving portion RP2, i.e. the second middle portion 133, is disposed between the first coil unit 120 and the second coil unit 130 in the horizontal direction.

Each of the first coil unit 120 and the second coil unit 130 may be a multiple-turn winding in which a rigid metallic conductor, e.g. a copper conductive wire, is wound multiple times, but the disclosure is not necessarily limited thereto. In addition, the thickness of the conductive wire constituting the second coil unit 130 may be 50% to 150% of the thickness of the conductive wire constituting the first coil unit 120, but the disclosure is not necessarily limited thereto.

Meanwhile, insulating units 161 and 162 may be disposed between the bobbins B1 and B2 and respective outer leg portions. The insulating units 161 and 162 may extend from a region on the upper surface of the second receiving portion RP2 to the outer side of the second receiving portion RP2, may then be bent and extend so as to surround the outer sides of the second receiving portion RP2 and the first extended portion EP1, and may then be bent and extend to a region on the lower surface of the first extended portion EP1. Accordingly, both the second coil unit 130 and the first coil unit 120 may be electrically isolated from the outer leg portions of the core unit 110. The insulating units 161 and 162 may include a material having a superior insulating property, such as ketone or polyimide, but the disclosure is not necessarily limited thereto.

Due to the above-described structure, an insulation distance between the first coil unit 120 and the core unit 110 may increase greatly. For example, if the second extended portion EP2 is not present, a first insulation distance PATH1, starting from the upper side of the first coil unit 120, extends directly to the lower surface of the upper bobbin. However, due to the presence of the second extended portion EP2, the first insulation distance PATH1 extends by a length equal to or longer than the length of the second extended portion in the x-axis direction. In addition, a second insulation distance PATH2, starting from the lower side of the first coil unit 120, extends by a length equal to the sum of the length of the first extended portion EP1 in the x-axis direction and the length of each of the insulating units 161 and 162 in the same direction.

Furthermore, in addition to the leakage inductance obtained through the shortest distance β between the first coil unit 120 and the second coil unit 130, additional leakage inductance may be secured due to misalignment between the first receiving portion RP1 and the second receiving portion RP2 in the horizontal direction.

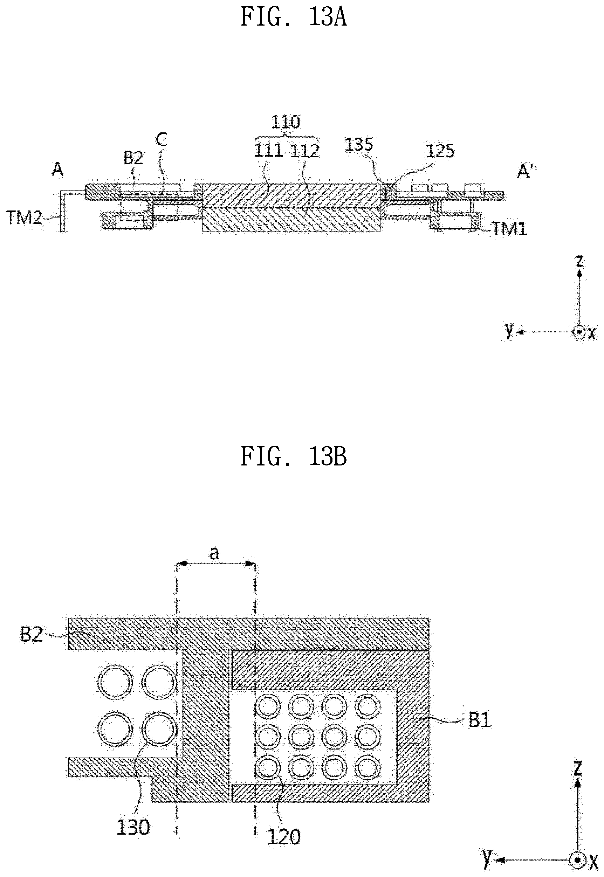

Hereinafter, sections of the parts that are not enveloped by the core unit 110 will be described with reference to FIGs. 13A and 13B.

FIG. 13A is a cross-sectional view of the transformer according to another embodiment, taken along line A-A' in FIG. 8B, and FIG. 13B is an enlarged view of portion C in FIG. 13A.

Referring to FIGs. 13A and 13B together, in the region in which the bobbin unit B1 and B2 is not enveloped by the core unit 110, the first extended portion EP1 may not be disposed in the first bobbin B1. Further, the shortest distance α between the first coil unit 120 and the second coil unit 130 in the region in which the bobbin unit B1 and B2 is not enveloped by the core unit 110, i.e. in the region outside the first space SB1 and the second space SB2, may be the same as or different from the shortest distance β between the first coil unit 120 and the second coil unit 130 in the region in which the bobbin unit B1 and B2 is enveloped by the core unit 110.

Preferably, a shortest-distance ratio (β/α) may be 1 to 1.3. When the shortest-distance ratio (β/α) is less than 1, the overall size of the transformer 101 is increased, and the change in leakage inductance is not large. On the other hand, when the shortest-distance ratio (β/α) exceeds 1.3, the energy conversion efficiency of the transformer 101 is reduced. However, the shortest-distance ratio (β/α) having the above range is a value determined when the cut line A-A' and the cut line B-B' in FIG. 8B intersect each other at the center of the center leg portion when viewed in a plan view, and may vary depending on the radius of curvature of each of the first middle portion 123 and the second middle portion 133 in the winding direction.

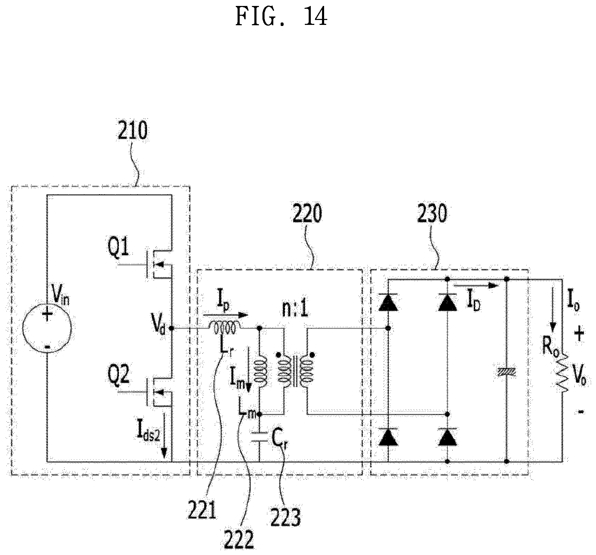

Hereinafter, the transformer 101 according to the embodiment and the configuration of a circuit in which the transformer 101 can be mounted will be described with reference to FIG. 14.

FIG. 14 shows an example of the configuration of a circuit of a power supply unit of an electronic product.

Referring to FIG. 14, the configuration of a circuit of a power supply unit (i.e. a PSU) of an electronic product including a square wave generator 210, a resonator 220, and a rectifier 230, for example, a flat panel TV, is illustrated. The flat panel TV generally supports not only a normal mode but also various other operation modes, such as a low-power mode, and is required to implement each operation mode with high efficiency. Therefore, the resonator 220 is implemented in the form of an LLC resonance converter. The LLC resonance converter includes a first inductor (Lr) 221, a second inductor (Lm) 222, and a capacitor (Cr) 223. The inductance (Lm) of the second inductor 222 can be considered to be the inductance that operates the circuit. The resonance frequency varies depending on the operation frequency of the PSU, and the inductance (Lr) of the first inductor 221 and the capacitance (Cr) of the capacitor 223 are factors determining the operation frequency. If the inductance (Lr) of the first inductor 221 and the capacitance (Cr) of the capacitor 223 are not set to appropriate values, the overall efficiency of the circuit may be deteriorated, or the circuit may malfunction.

The inductance (L) value of the leakage-inductance-integrated transformer, such as the transformer 101 according to the embodiment, corresponds to "Lm" in the resonator 220, and the leakage inductance (Lk) value thereof corresponds to "Lr" in the resonator 220.

A ratio (Lk/Lm) required for a PSU of a general flat panel TV is 10 to 20%, but the value of "Lk" of a conventional transformer is too low to meet the ratio requirement.

In more detail, the leakage inductance of the transformer may be obtained using Equation 1 below.

[Equation 1]

$$L_k = (1-k) * L_m$$

In Equation 1, "$L_k$" represents leakage inductance, "k" represents a coupling coefficient, and "$L_m$" represents the inductance of the transformer. Here, the coupling coefficient k may be obtained through experimentation, and, for example, may be obtained using Equation 2 below.

[Equation 2]

$$k = 0.7307 - [0.0556 * In(X)]$$

In Equation 2, "X" represents a gap ratio, specifically, a ratio of the spacing distance between the first coil unit and the second coil unit to the shortest distance between the outermost periphery of the first coil unit and the outer leg portion adjacent thereto, which define a space in which the second coil unit can be wound (hereinafter referred to as a "winding space" for convenience).

In more detail, when both the first bobbin B1 and the second bobbin B2 are present, the shortest distance (i.e. β in FIG. 5) between the first coil unit 120 and the second coil unit 130 corresponds to the distance between the outermost periphery of the first coil unit 120 and the innermost periphery of the second coil unit 130. Further, if only the first bobbin B1 is present, the maximum allowable value of the distance between the second coil unit 130 and the first coil unit 120 in the winding space in which the second coil unit 130 can be present corresponds to the shortest distance (i.e. d1 in FIG. 12) from the outermost periphery of the first coil unit 120 to the outer leg portion adjacent thereto.

The leakage inductance of the transformer varies depending on the coupling coefficient, and the coupling coefficient is particularly influenced by the shortest distance between the first coil unit 120 and the second coil unit 130 in the core unit 110.

However, the shortest distance β between the first coil unit 120 and the second coil unit 130 is determined depending on the position at which the innermost periphery of the second coil unit 130 is located in the winding space. When only the increase in the shortest distance β is of concern, the number of turns of the second coil unit 130 is limited in a confined winding space. Further, because the size of the core unit 110 needs to be increased in order to increase the size of the winding space, there is a limitation on the extent to which the size of the winding space can be increased.

Therefore, in the embodiment, the leakage inductance may be secured by controlling a gap ratio, i.e. a ratio of the shortest distance β between the first coil unit 120 and the second coil unit 130 to the shortest distance d2 from the outermost periphery of the first coil unit 120 to the outer leg portion adjacent thereto.

For example, the shortest distance β between the first coil unit 120 and the second coil unit 130 is preferably 0.1 to 0.3 times as long as "d1". If the ratio is less than 0.1, LLC matching of a circuit board (e.g. a PSU) on which the transformer is mounted may be lost, and thus the operation frequency may rise, which may cause a problem in that control of the board becomes impossible. If the ratio exceeds 0.3, the efficiency of the transformer 101 may be deteriorated, and oscillation may occur on the board. However, this example is given on the assumption that a general PSU is used, and the disclosure is not necessarily limited thereto, depending on the type of circuit in which the transformer is mounted.

Consequently, referring to Equations 1 and 2, the leakage inductance is influenced by the coupling coefficient k, and the coupling coefficient is influenced by the distance between the first coil unit and the second coil unit and the overlapping area therebetween. In the transformer 101 according to the embodiment, the coupling coefficient is reduced by controlling the spacing distance between the first coil unit and the second coil unit in order to increase leakage inductance, and additional leakage inductance is secured by misaligning the receiving space for the first coil unit and the receiving space for the second coil unit from each other in the horizontal direction.

Therefore, the transformer according to the embodiment is capable of being slimmed due to the above-described coupling structure of the bobbin unit and is capable of securing a high Lk value, and thus is suitable for constitution of a power supply unit of a flat panel TV.

According to the transformer 101 of the embodiment described above, in at least a region in which the bobbin unit B1 and B2 is enveloped by the core unit 110, the second receiving portion RP2 is disposed on the first extended portion EP1, and the first receiving portion RP1 is disposed under the second extended portion EP2 due to the coupling structure of the bobbin unit B1 and B2, whereby the first receiving portion RP1 and the second receiving portion RP2 do not at least partially overlap each other in the horizontal direction. However, according to another embodiment, the space in which the first coil unit 120 is received and the space in which the second coil unit 130 is received may be parallel to each other.

While the present disclosure has been particularly shown and described with reference to exemplary embodiments thereof, these embodiments are only proposed for illustrative purposes and do not restrict the present disclosure, and it will be apparent to those skilled in the art that various changes in form and detail may be made without departing from the essential characteristics of the embodiments set forth herein. For example, respective configurations set forth in the embodiments may be modified and applied. Further, differences in such modifications and applications should be construed as falling within the scope of the present disclosure as defined by the appended claims.

[Mode for Invention]

Various embodiments have been described in the best mode for carrying out the disclosure.

**Claims**

1. A transformer, comprising:

    a core unit including an upper core and a lower core;
    a first coil unit and a second coil unit at least partially disposed between the upper core and the lower core; and
    a terminal bobbin coupled to one side of the second coil unit in a first direction,
    wherein the first coil unit includes: a first coil; and a first bobbin having a first through-hole through which a center leg of the core unit passes, the first bobbin receiving the first coil,
    wherein the second coil unit includes: a second coil; and a second bobbin having a second through-hole receiving at least a portion of the first coil unit, the second bobbin receiving the second coil,
    wherein the terminal bobbin includes: a plurality of first terminals disposed on one side of the terminal bobbin that is oriented in the first direction so as to be spaced apart from each other in a second direction intersecting the first direction; and an opening formed in another side opposite the one side in the first direction to allow the one side of the second coil unit to be inserted thereinto, and
    wherein two end portions of the first coil are led out from the first bobbin and are respectively connected to different first terminals among the plurality of first terminals of the terminal bobbin.

2. The transformer according to claim 1, wherein the first bobbin includes:

    a first top plate; a bottom plate spaced apart from the first top plate in a third direction intersecting the first direction and the second direction; and a first side wall disposed between the top plate and the bottom plate, and wherein the first top plate includes:
    a lead-out hole allowing the two end portions to be led out to a region on the first top plate therethrough.

3. The transformer according to claim 1, wherein the second bobbin includes:
    a second top plate; a second bottom plate spaced apart from the second top plate in a third direction intersecting the first direction and the second direction; and a second side wall disposed between the second top plate and the second bottom plate.

4. The transformer according to claim 3, comprising:

    a first portion disposed on one side of the second bobbin that is oriented in the first direction with respect to the second through-hole; and
    a second portion disposed on another side opposite the first portion with respect to the second through-hole,
    wherein the second coil includes a plurality of conductive wires disposed around the second through-hole,
    wherein one side of each of the plurality of conductive wires extends so as to be disposed on the second portion,
    wherein another side of each of the plurality of conductive wires extends such that two ends of each of the plurality of conductive wires are disposed on the first portion,
    wherein a first conductive wire and a second conductive wire among the plurality of conductive wires at least partially overlap each other on the second portion, and
    wherein the second bobbin includes:
    a recess at least partially overlapping, in the third direction, a region of the second portion on which the first conductive wire and the second conductive wire overlap each other.

**5.** The transformer according to claim 4, wherein the second bobbin further includes:
a second partition wall portion protruding from the second bottom plate downwards in the third direction between the second through-hole and the recess and extending in the second direction.

**6.** A transformer, comprising:

a core unit comprising an upper core and a lower core;
a coil unit partially disposed in the core unit; and
a bobbin unit disposed between the core unit and the coil unit,
wherein the coil unit includes:

a first coil and a second coil at least partially disposed beside the first coil,
wherein the bobbin unit includes:

a first bobbin including a first receiving portion formed therein to receive the first coil; and
a second bobbin including a second receiving portion formed therein to receive the second coil,
wherein the first bobbin includes a first extended portion extending from the first receiving portion toward the second bobbin, and
wherein the second receiving portion is disposed on the first extended portion.

**7.** The transformer according to claim 6, wherein the first bobbin includes:

a first top portion;
a first bottom portion disposed below the first top portion; and
a first middle portion disposed between the first top portion and the bottom portion, the first middle portion including a first through-hole defined by an inner side surface thereof, and
wherein the first extended portion is disposed on the first bottom portion.

**8.** The transformer according to claim 6, wherein the second bobbin includes:

a second top portion including a second through-hole formed in a center portion thereof;
a second bottom portion disposed below the second top portion; and
a second middle portion disposed between the second top portion and the second bottom portion, and
wherein the first bobbin is at least partially received in a recess defined by a lower surface of the second top portion and an inner side surface of the second middle portion.

**9.** The transformer according to claim 6, wherein a shortest distance from a lower surface of the lower core to the first coil and a shortest distance from a lower surface of the lower core to the second coil are different from each other.

**10.** The transformer according to claim 6, wherein the core unit includes:

a first outer leg portion, a second outer leg portion, and a center leg portion disposed between the first outer leg portion and the second outer leg portion, and
wherein a shortest distance between the first coil and the second coil is 0.1 times to 0.3 times a shortest distance from an outermost periphery of the first coil to one outer leg portion adjacent thereto, among the first outer leg portion and the second outer leg portion.

FIG. 1

# FIG. 2A

FIG. 2B

FIG. 2C

FIG. 3A

FIG. 3B

# FIG. 4A

# FIG. 4B

FIG. 4C

FIG. 5A

FIG. 5B

# FIG. 6

# FIG. 7A

FIG. 7B

# FIG. 7C

FIG. 7D

FIG. 7E

FIG. 7F

FIG. 7G

FIG. 8A

FIG. 8B

# FIG. 9

FIG. 10

FIG. 11

FIG. 12

# FIG. 13A

# FIG. 13B

FIG. 14

## INTERNATIONAL SEARCH REPORT

| International application No. |
|---|
| **PCT/KR2022/001022** |

### A. CLASSIFICATION OF SUBJECT MATTER

**H01F 27/32**(2006.01)i; **H01F 27/24**(2006.01)i; **H01F 27/30**(2006.01)i; **H01F 27/34**(2006.01)i; **G09F 9/00**(2006.01)i; **H01F 27/26**(2006.01)i; **H01F 27/28**(2006.01)i; **H01F 27/29**(2006.01)i; **H01F 27/06**(2006.01)i

According to International Patent Classification (IPC) or to both national classification and IPC

### B. FIELDS SEARCHED

Minimum documentation searched (classification system followed by classification symbols)

H01F 27/32(2006.01); G09G 3/36(2006.01); H01F 17/04(2006.01); H01F 27/02(2006.01); H01F 27/24(2006.01); H01F 27/28(2006.01); H01F 27/29(2006.01); H01F 27/30(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 트랜스포머(transformer), 코어(core), 코일(coil), 보빈(bobbin), 터미널 보빈 (terminal bobbin)

### C. DOCUMENTS CONSIDERED TO BE RELEVANT

| Category* | Citation of document, with indication, where appropriate, of the relevant passages | Relevant to claim No. |
|---|---|---|
| X | KR 10-1686975 B1 (TDK KOREA CO., LTD.) 20 January 2017 (2017-01-20)<br>See paragraphs [0020], [0030], [0046] and [0054]; and figures 1a-6c. | 6-10 |
| Y | | 1,3 |
| A | | 2,4-5 |
| Y | KR 10-2014-0003131 A (SAMSUNG ELECTRO-MECHANICS CO., LTD.) 09 January 2014 (2014-01-09)<br>See paragraphs [0060] and [0088]; and figures 3-5b. | 1,3 |
| A | KR 10-2110344 B1 (MST TECH CO., LTD.) 14 May 2020 (2020-05-14)<br>See claim 1; and figures 2-9. | 1-10 |
| A | KR 10-2012-0076299 A (SAMSUNG ELECTRO-MECHANICS CO., LTD.) 09 July 2012 (2012-07-09)<br>See claims 1-30; and figures 1-6. | 1-10 |

☑ Further documents are listed in the continuation of Box C.  ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **19 May 2022** | **23 May 2022** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2019)

## INTERNATIONAL SEARCH REPORT

| International application No. |
| --- |
| **PCT/KR2022/001022** |

**C.    DOCUMENTS CONSIDERED TO BE RELEVANT**

| Category* | Citation of document, with indication, where appropriate, of the relevant passages | Relevant to claim No. |
| --- | --- | --- |
| E | KR 10-2022-0010446 A (LG INNOTEK CO., LTD.) 25 January 2022 (2022-01-25)<br>See claims 1-16; and figures 1-16. | 6-10 |

Form PCT/ISA/210 (second sheet) (July 2019)

**INTERNATIONAL SEARCH REPORT**
Information on patent family members

International application No.

**PCT/KR2022/001022**

| Patent document cited in search report | | | Publication date (day/month/year) | Patent family member(s) | | | Publication date (day/month/year) |
|---|---|---|---|---|---|---|---|
| KR | 10-1686975 | B1 | 20 January 2017 | CN | 106571212 | A | 19 April 2017 |
| KR | 10-2014-0003131 | A | 09 January 2014 | CN | 103515047 | A | 15 January 2014 |
| | | | | CN | 202855466 | U | 03 April 2013 |
| | | | | KR | 10-1388797 | B1 | 23 April 2014 |
| | | | | US | 2014-0002224 | A1 | 02 January 2014 |
| | | | | US | 9019056 | B2 | 28 April 2015 |
| KR | 10-2110344 | B1 | 14 May 2020 | CN | 112823401 | A | 18 May 2021 |
| | | | | CN | 112823402 | A | 18 May 2021 |
| | | | | KR | 10-2066735 | B1 | 15 January 2020 |
| | | | | KR | 10-2091117 | B1 | 19 March 2020 |
| | | | | KR | 10-2132848 | B1 | 13 July 2020 |
| | | | | WO | 2020-138991 | A1 | 02 July 2020 |
| | | | | WO | 2020-138993 | A1 | 02 July 2020 |
| KR | 10-2012-0076299 | A | 09 July 2012 | KR | 10-1124147 | B1 | 21 March 2012 |
| KR | 10-2022-0010446 | A | 25 January 2022 | KR | 10-2394405 | B1 | 06 May 2022 |
| | | | | WO | 2022-015073 | A1 | 20 January 2022 |

Form PCT/ISA/210 (patent family annex) (July 2019)